# EUROPEAN PATENT APPLICATION

(11) **EP 0 905 288 A1**
(43) Date of publication of application: **31.03.1999**
(21) Application number: 97903636.5
(22) Date of filing: 28.02.1997
(51) Int. Cl.: C30B 25/16, C30B 29/06, C23C 16/24, H01L 21/205

(54) **PROCESS FOR PREPARING SEMICONDUCTOR MONOCRYSTALLINE THIN FILM**

(30) Priority: 01.03.1996 JP 71045/96
(71) Applicant: Shin-Etsu Handotai Co., Ltd., Chiyoda-ku, Tokyo 100 (JP)
(72) Inventor: HABUKA, Hitoshi, Shin-Etsu Handotai Co., Ltd., Annaka-shi, Gunma 379-01 (JP)
(74) Representative: Cooper, John
(86) International application number: JP9700619
(87) International publication number: WO9732060

(57) **Abstract**

A method for fabricating semiconductor single crystal thin film by supplying a reducing gas onto the surface of a semiconductor single crystal substrate to pretreat the substrate for removing an oxide film from the surface of the substrate, and then supplying a reaction gas onto the surface of the substrate to perform vapor phase growth, wherein the ratio P₂/P₁, wherein P₁ represents the reaction vessel pressure in the step of pre-treatment and P₂ represents the highest pressure of the reaction vessel which reaches in a period between the completion of the pre-treatment step and the start of vapor phase growth step, is brought to at least 10. For example, when a silicon single crystal thin film is grown on a silicon single crystal substrate, P₁ is brought to 0.1 atm (absolute pressure), while P₂ is brought to 1 atm (absolute pressure). This enables the production of an epitaxial layer grown on a substrate by vapor phase growth, wherein the dopant concentration is abruptly changed in the interface between the substrate and the thin film.

## Description

### TECHNICAL FIELD

This invention relates to a method for fabricating a semiconductor single crystal thin film by a vapor phase growth.

### BACKGROUND ART

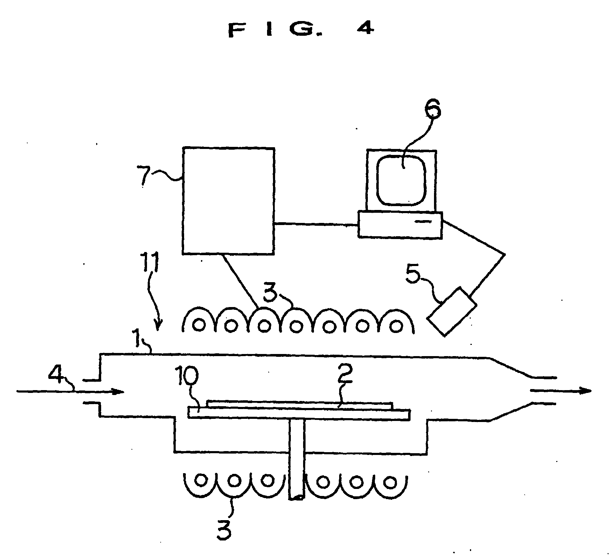

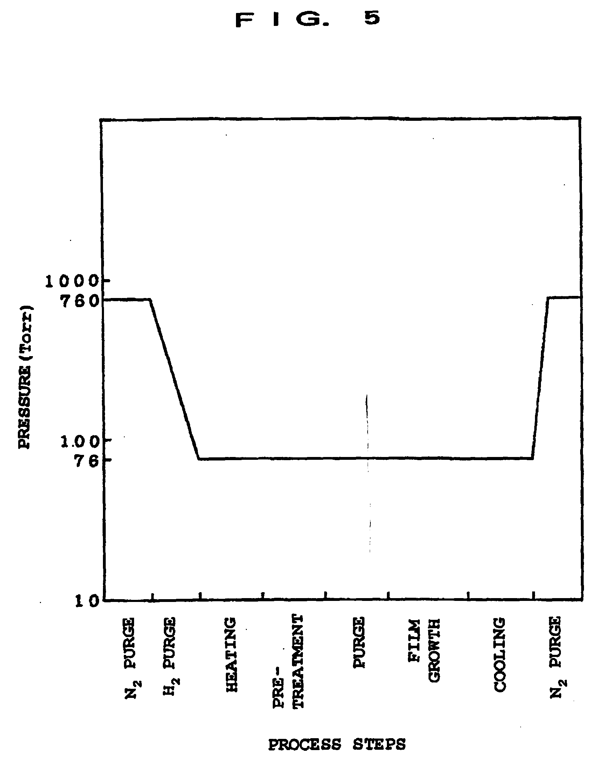

For example, when it is desired to form a thin film of silicon single crystal on a silicon single crystal substrate, such an apparatus as shown in Fig. 4 is used to sequentially perform pre-treatment step and a vapor phase growth step as shown in Fig. 5.

### (1) Pre-Treatment Step (of removing silicon oxide film on a substrate):

A silicon single crystal substrate 2 is placed on a susceptor 10 as inside reaction vessel 11 made of transparent silica glass as parallel to a wall 1 of the reaction vessel 11, and a nitrogen gas is supplied into the reaction vessel 11 to purge air in the vessel 11. Next, after the nitrogen gas is purged by a hydrogen gas, a substrate 2 is heated by a radiation heater 3 provided on upper and lower sides of the vessel wall 1 while the hydrogen gas is continuously supplied, to thereby maintain a substrate temperature suitable for the pre-treatment process for a predetermined time. In this case, radiation light emitted from the substrate 2 is detected by a radiation thermometer 5 which is in turn converted its intensity by a computer 6 to a temperature and also sent the temperature to a temperature controller 7 to thereby supply a necessary power to the radiation heater 3. In the pre-treatment step, usually, a temperature of the substrate 2 is set and kept at a level higher than the temperature in the vapor phase growth process, and a pressure within the reaction vessel 11 is maintained at the same level as in the vapor phase growth process.

A native oxide film already formed on the substrate due to oxygen in the air, that is, a silicon oxide film or a silicon oxide film intentionally formed is removed for example by hydrogen reduction in a high-temperature during the pre-treatment step. By removing the silicon oxide film formed on the substrate previously, there can he formed a silicon single crystal thin film with a good crystallization in the vapor phase growth step.

### (2)Vapor Phase Growth Step (forming a silicon single crystal thin film):

A reactant gas 4 containing a carrier gas and a reactant raw material is flown over a front surface side of the substrate 2. When the substrate 2 is set to have a temperature suitable for growth of a silicon single crystal thin film, e.g., of 800 to 1200°C, a chemical reaction of the reactant gas 4 causes a silicon single crystal thin film to grow on the substrate 2.

In the aforementioned semiconductor single crystal thin film fabrication method, however, since the reaction vessel 11 has a high-temperature environment therein, when such a low-resistivity silicon substrate having a dopant concentration of especially 1 x 10²⁴ atoms/m³ or more is employed, dopants are liberated from the substrate due to outdiffusion or etching and scattered into the reaction vessel 11 during the pre-treatment step, which leads to occurrence of an autodoping phenomenon in which the scattered dopants are mixed into the silicon single crystal thin film during the vapor phase growth process. This disadvantageously results in formation of an epitaxial layer grown on the substrate in which, although a dopant concentration shall be changed desirably abruptly at an interface between the thin film and substrate, the concentration becomes actually highly dull with a gentle gradient and with a large transition width. The transition width means a width necessary for transition from the dopant concentration of the substrate to that of the thin film.

In view of the above problems in the prior art, the present invention has been made, and an object thereof is to provide a method for fabricating a semiconductor single crystal thin film by sequentially performing a pre-treatment step (of removing an oxide film on a substrate) and a vapor phase growth step (of forming the semiconductor single crystal thin film) to thereby obtain an epitaxial layer grown on the substrate in which a dopant concentration can be abruptly changed at an interface between the substrate and the thin film.

### DISCLOSURE OF INVENTION

A method for fabricating a semiconductor single crystal thin film in accordance with the present invention wherein a pre-treatment step to remove an oxide film on a surface of a semiconductor single crystal substrate placed within a reaction vessel by supplying a reducing gas onto the substrate surface is carried out and thereafter a vapor phase growth step of supplying a reactant gas onto said substrate surface to perform its vapor phase growth treatment is carried out, is featured by including a step of setting a reaction vessel pressure to be higher than the pre-treatment step, during a time after completion of the pre-treatment step and before start of the vapor phase growth step.

Said pre-treatment step may be carried out either under reduced pressure or under a normal pressure condition.

The inventor of the present application has examined the reason why the transition width becomes large at the interface between the silicon substrate and silicon thin film in the aforementioned prior art method, and as a result of the examination, he has estimated that dopant atoms (more accurately, molecules having the dopant atoms as their constituent atoms) leading to the cause of the auto-doping phenomenon of the silicon thin film are liberated therefrom due to the outdiffusion or etching mainly in the high-temperature pre-treatment step and long float in the vicinity of the substrate during the vapor phase growth process.

The present inventor has, on the basis of the above estimation, conducted a test that a reaction vessel pressure during a time after completion of the pre-treatment step and before start of a vapor phase growth step is set to be higher than a pre-treatment step in order to efficiently remove dopant atoms liberated from a substrate to reduce a dopant atom concentration in the vicinity of the substrate, and has confirmed that the object of the present invention can be attained.

That is, in accordance with the present invention, during the time after completion of the pre-treatment step and before start of the vapor phase growth step, the reaction vessel pressure is set to be higher than the pre-treatment step to abruptly increase a carrier gas flow and thereby to efficiently dilute and substitute the dopant atoms remaining in the vicinity of the substrate with the carrier gas. As the result, the amount of dopant atoms long floating in the vicinity of the substrate and being mixed into the semiconductor single crystal thin film during the vapor phase growth is abruptly decreased to thereby attain the object of the present invention.

### BRIEF DESCRIPTION OF THE DRAWINGS

Fig. 1 is a graph showing process of fabricating a semiconductor single crystal thin film and pressure conditions in accordance with an embodiment of the present invention.
Fig. 2 is a schematic cross-sectional view of an apparatus for fabricating a semiconductor single crystal thin film in accordance with an embodiment of the present invention.
Fig. 3 is a graph showing a result of the embodiment of the present invention and a result of a comparative example in a prior art for comparison.
Fig. 4 is a schematic cross-sectional view of an exemplary prior art apparatus of fabricating a semiconductor single crystal thin film.
Fig. 5 is a graph showing steps of fabricating a semiconductor single crystal thin film and pressure conditions in the prior art method.

### BEST MODE FOR CARRYING OUT THE INVENTION

A method for fabricating a semiconductor single crystal thin film in accordance with the present invention wherein a pre-treatment step to remove an oxide film on a surface of a semiconductor single crystal substrate placed within a reaction vessel by supplying a reducing gas onto the substrate surface is carried out and thereafter a vapor phase growth step of supplying a reactant gas onto said substrate surface to perform its vapor phase growth treatment is carried out, is featured by including a step of setting a reaction vessel pressure to be higher than the pre-treatment step, during a time after completion of the pre-treatment step and before start of the vapor phase growth step.

Said pre-treatment step may be carried out either under reduced pressure or under a normal pressure condition.

In the present invention, assuming that a reaction vessel pressure in a pre-treatment step is denoted by P₁ (absolute pressure), and the highest pressure of the reaction vessel reaching during a time after completion of the pre-treatment step and before start of a vapor phase growth step is denoted by P₂ (absolute pressure), then it is preferable that, in order to efficiently remove dopant atoms floating in the vicinity of a substrate, a ratio P₂/P₁ be 10 or more.

Further, when P₂ is a normal pressure (atmospheric pressure), P₁ is set to be preferably between 1 Torr and 76 Torr, and practically it is unnecessary to set the ratio P₂/P₁ to be larger than 760.

In the present invention, the vapor phase growth step may be carried out in a vacuum condition not less than 1 Torr and lower than 760 Torr. Further, the vapor phase growth step may be carried out in an atmospheric pressure.

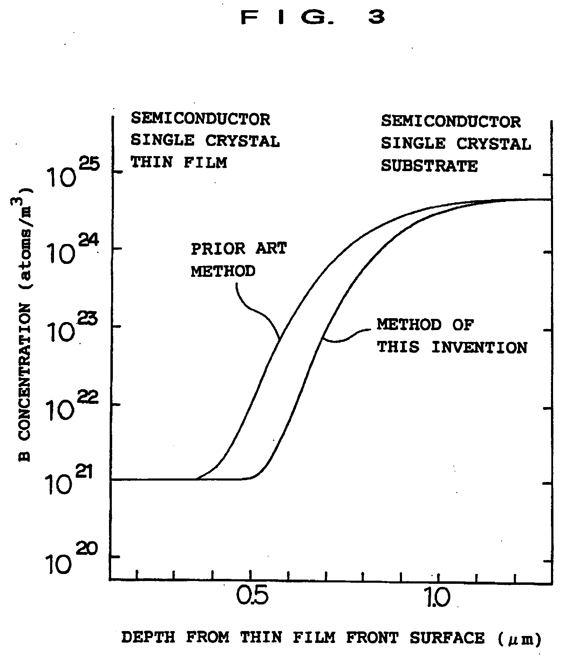

The present invention is suitable when it is desired to grow a semiconductor single crystal thin film in such a manner that a dopant concentration (atoms/m³) of the semiconductor single crystal thin film front surface is, e.g., 3 or more orders of magnitude lower than the dopant concentration (atoms/m³) of the substrate as shown in Fig. 3. However, it is difficult even by the present invention to grow such a film in such a manner the dopant concentration of the film front surface is 6 orders of magnitude lower than the dopant concentration of the substrate. In this connection, "3 or more orders of magnitude lower" means that, as shown in Fig. 3 for example, the dopant concentration of the semiconductor single crystal substrate is on the order of 10²⁴ (atoms/m³), while the dopant concentration of the semiconductor single crystal thin film front surface is on the order of 10²¹ (atoms/m³). Further, the "suitable" means that the dopant concentration is abruptly changed in the depth direction of the semiconductor single crystal thin film and the transition width is suitably 0.5µm or less.

A typical example of the method for fabricating a semiconductor single crystal thin film in accordance with the present invention is to use a silicon single crystal substrate as a semiconductor single crystal substrate to grow a silicon single crystal thin film as the semiconductor single crystal thin film by a vapor phase growth process.

That is, as the typical example of the method for fabricating a semiconductor single crystal thin film in accordance with the present invention, there is a recommendable method for fabricating a semiconductor single crystal thin film wherein a pre-treatment step to remove an oxide film on a surface of a silicon single crystal substrate placed within a reaction vessel by supplying reducing hydrogen gas onto the substrate surface is carried out and thereafter a vapor phase growth step of supplying a reactant gas onto the substrate to grow a silicon single crystal film is carried out, and which is featured in that the reaction vessel is maintained under reduced pressure of 1 Torr to 76 Torr in absolute pressure in the pre-treatment step, and the highest pressure of the reaction vessel reaching during a time after completion of the pre-treatment step and before start of the vapor phase growth step is set at nearly atmospheric pressure.

### Examples:

The feature, function and effect of the present invention will next be explained in connection with examples shown in the drawings.

### Example 1:

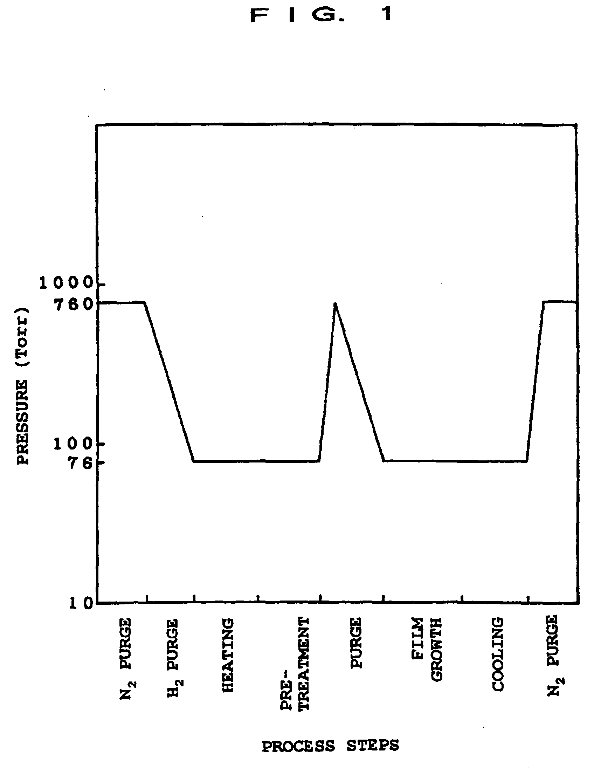

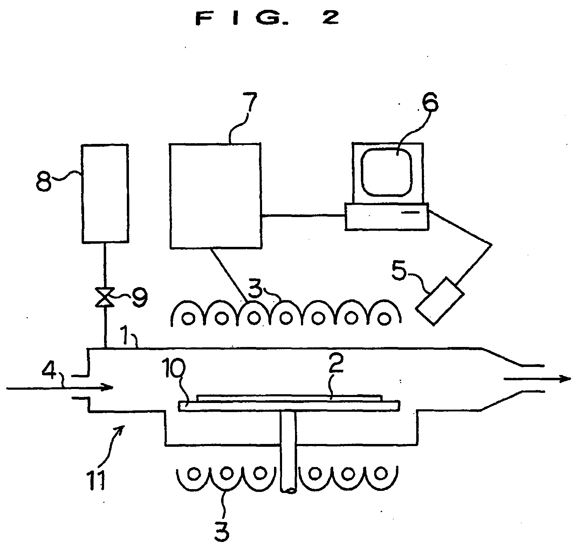

Fig. 1 is a graph showing steps of fabricating a semiconductor single crystal thin film and a variation in pressure. As shown in Fig. 2, a reaction vessel 11 made of transparent silica glass was horizontally arranged and a silicon single crystal substrate 2 was placed on a susceptor 10 as parallel to a wall 1 of the reaction vessel 11 (that is, horizontally) within the vessel wall 1. A substrate 2 which contains borons (B) as dopants at a concentration of 6 x 10²⁴ atoms/m³ was used.

Connected to a gas discharge side of the reaction vessel 11 is a discharge piping, which is branched into two pipes on its way. One of the branched pipes is connected to a vacuumizing device as a vacuum discharge pipe, while the other thereof is connected to a normal pressure exhaust device as a normal pressure discharge pipe. Provided to the vacuum discharge pipe is a pressure control valve whose opening can be automatically adjusted. Connected to the normal pressure discharge pipe in series therewith is a switch valve whose opening can be automatically adjusted.

A nitrogen gas was first supplied from a gas supply nozzle into the reaction vessel 11 to expel the air from inside of the reaction vessel 11 (N₂ purging step). The expelling was carried out by means of the aforementioned normal pressure exhaust device.

Next, supply of the nitrogen gas was stopped and supply of a hydrogen gas from the gas supply nozzle into the reaction vessel 11 was started while the pressure of the reaction vessel 11 was lowered to 0.1 atm. or 76 Torr (absolute pressure) by means of the above vacuumizing device (H₂ purging step). The pressure adjustment was carried out by controlling the above pressure control valve. Subsequently, the substrate 2 was heated by a radiation heater 3 to a temperature of 1190°C suitable for the pre-treatment step while the hydrogen gas was supplied (heat up step). During the heating operation, as in the above prior art method, radiation light emitted from the substrate 2 was caught by a radiation thermometer 5, which sent its intensity to a computer 6 to convert the intensity to a temperature therein. The measured temperature was sent to a temperature controller 7 to apply a necessary power to the radiation heater 3.

Next, the substrate 2 was kept in a hydrogen atmosphere at 1190°C for 1.5 minutes to remove a silicon oxide film on a main front surface of the substrate (pre-treatment step). Thereafter during a time after completion of the pre-treatment step and before start of the vapor phase growth step, a flow control valve 9 of a hydrogen tank 8 connected to a supply side of a reactant gas 4 was gradually opened, concurrently with lowering of the temperature of the substrate 2 down to 1100°C, to thereby introduce a large quantity of hydrogen gas into the reaction vessel 11, whereby the internal pressure of the reaction vessel 11 was raised to 1 atm. (absolute pressure). A hydrogen supply pipe and a pressure control value both not illustrated are provided to the hydrogen tank 8 so that the internal pressure of the hydrogen tank 8 is kept at nearly constant one atmosphere. These operations were carried out throughout one minute (purging step). The pressure raising is carried out preferably in a short time and, when it is carried out within 5 minutes, its effect becomes great. In this case, in place of a large quantity of hydrogen gas introduced from the hydrogen tank 8, the flow rate of hydrogen gas supplied from the gas supply nozzle may be abruptly increased to raise the internal pressure of the reaction vessel 11 to 1 atm. Further, the use of the vacuumizing device may be switched into the use of the normal pressure exhaust device to raise the pressure.

After the internal pressure of the reaction vessel 11 was raised to 1 atm. the pressure was again lowered to a pressure for the thin film growth e.g., to 76 Torr.

Next, a mixture gas of a source gas supplying trichlorosilane at a rate of 22g/min. diluted with the hydrogen gas and a hydrogen gas containing diborane (B₂H₆) supplied at a rate of 100cc/min. as the reaction gas 4 was supplied onto the substrate 2 to grow a silicon single crystal thin film having a front surface dopant concentration of 1 x 10²¹ atoms/m³ for one minute (thin film growing step). After the vapor phase growth step was completed by stopping the supply of trichlorosilane and diborane, the heating was stopped to decease the temperature of the substrate 2 in the hydrogen atmosphere (temperature lowering step). Finally, the internal pressure of the reaction vessel 11 was raised to 1 atm. while nitrogen was introduced into the reaction vessel 11 (N₂ purging step). A substrate with an epitaxial layer thereon thus obtained was unloaded therefrom, and an interface between the substrate 2 and silicon single crystal thin film was subjected to a measurement by a secondary ion mass spectroscopy. Its measurement result is shown in Fig. 3. In the drawing, abscissa denotes a position from the front surface of the silicon single crystal thin film in its depth direction, and ordinate denotes boron atom concentration (atoms/m³).

Next, explanation will be made as to a comparative test in which a silicon single crystal thin film was formed on the substrate 2 under such conditions as shown in Fig. 5 with use of such a prior art apparatus as shown in Fig. 4.

### COMPARATIVE EXAMPLE 1:

The conditions of this EXAMPLE were set to be the same as those in the EXAMPLE 1, except that the internal pressure of the reaction vessel 11 was set and maintained at 0.1 atm. (absolute pressure) in all steps ranging from the pre-treatment step to the vapor phase growth step. An interface between the substrate 2 and silicon single crystal thin film thus obtained was subjected to a measurement by the secondary ion mass spectroscopy. Its measurement result was also given in Fig. 3.

As will be obvious from Fig. 3, according to the method of the present invention, the dopant concentration at the interface between the substrate and semiconductor single crystal thin film was able to be more abruptly changed than that in the prior art method and thus an epitaxial layer grown on a substrate having a narrower transition width than a conventional one by 0.2µm was able to be fabricated. In addition, it has been confirmed that, even when the substrate has a temperature of 1100°C in the vapor phase growth step, a preferable dopant concentration profile can be realized.

As a result of analysis of the above result based on the method of the present invention, it has been found that a boron concentration distribution in a silicon substrate surface layer region corresponding to 0.8 to 1.3µm of abscissa's values in Fig. 3 is obtained by borons' outdiffusion from the interior of the silicon substrate. In other words, it has been confirmed that, in this region, the amount of boron atoms mixed into the silicon single crystal thin film from the atmosphere in the vicinity of the substrate is as small as negligible.

Although the pressure was again lowered down to 76 Torr for the vapor phase growth process of the thin film after the pressure increase in the purging step in the present embodiment, the pressure for the vapor phase growth may be a vacuum level not lower than 1 Torr and lower than 760 Torr or atmospheric pressure, under which condition the object of the present invention can be sufficiently attained.

As has been explained in the foregoing, the method for fabricating a semiconductor single crystal thin film in accordance with the present invention includes a step of setting the reaction vessel pressure to be higher than the pre-treatment step, during a time after completion of the pre-treatment step and before start of the vapor phase growth step, whereby the concentration of dopant atoms long remaining in the vicinity of the substrate can be quickly diluted, and the amount of dopant atoms long remaining in the vicinity of the substrate and being mixed into the semiconductor single crystal thin film during the vapor phase growth can be abruptly decreased. As a result, there can advantageously be grown an epitaxial layer on a substrate which the dopant concentration at the interface between the substrate and semiconductor single crystal thin film is more abruptly changed than that in the prior art method.

## Claims

1. A method for fabricating a semiconductor single crystal thin film wherein a pre-treatment step to remove an oxide film on a surface of a semiconductor single crystal substrate placed within a reaction vessel by supplying a reducing gas onto the substrate surface is carried out and thereafter a vapor phase growth step of supplying a reactant gas onto said substrate surface to perform its vapor phase growth treatment is carried out, is characterized by including a step of setting a reaction vessel pressure to be higher than the pre-treatment step, during a time after completion of the pre-treatment step and before start of the vapor phase growth step.

2. A method for fabricating a semiconductor single crystal thin film as set forth in claim 1, characterized in that a dopant concentration (atoms/m³) of the front surface of said semiconductor single crystal thin film is 3 or more orders of magnitude lower than a dopant concentration (atoms/m³) of the substrate.

3. A method for fabricating a semiconductor single crystal thin film as set forth in claim 1 or 2, characterized in that, when a reaction vessel pressure in the pre-treatment step is denoted by P₁ (absolute pressure) and the highest pressure of the reaction vessel reaching during a time after completion of the pre-treatment step and before start of the vapor phase growth step is denoted by P₂ (absolute pressure), a ratio P₂/P₁ is set to be 10 or more.

4. A method for fabricating a semiconductor single crystal thin film as set forth in claim 3, characterized in that the pressure P₂ is atmospheric pressure and the pressure P₁ is 1 Torr or higher.

5. A method for fabricating a semiconductor single crystal thin film as set forth in claim 1, 2, 3 or 4, characterized in that a silicon single crystal substrate is used as the semiconductor single crystal substrate, and a silicon single crystal thin film is grown as the semiconductor single crystal thin film.

6. A method for fabricating a semiconductor single crystal thin film as set forth in any of claims 1 to 5, characterized in that said vapor phase growth step is carried out in a vacuum condition not less than 1 Torr and lower than 760 Torr.

7. A method for fabricating a semiconductor single crystal thin film as set forth in any of claims 1 to 5, characterized in that said vapor phase growth step is carried out in the atmospheric pressure.

8. A method for fabricating a semiconductor single crystal thin film wherein a pre-treatment step to remove an oxide film on a surface of a silicon single crystal substrate placed within a reaction vessel by supplying reducing gas onto said substrate surface is carried out and thereafter a vapor phase growth step of supplying a reactant gas onto the substrate to grow a silicon single crystal film is carried out, and which is characterized in that the reaction vessel is maintained under reduced pressure of 1 Torr to 76 Torr in absolute pressure in the pre-treatment step, and the highest pressure of said reaction vessel reaching during a time after completion of the pre-treatment step and before start of the vapor phase growth step is set at nearly atmospheric pressure.
